# EUROPÄISCHE PATENTSCHRIFT

(11) **EP 3 878 245 B1**
(45) Veröffentlichungstag und Bekanntmachung des Hinweises auf die Patenterteilung: **02.04.2025**
(21) Anmeldenummer: 19797667.3
(22) Anmeldetag: 30.10.2019
(51) Int. Cl.: H05K 3/00, H05K 1/02, H05K 3/40, B42D 25/48, B23K 26/06, B23K 26/067, H05K 1/11, H05K 3/12, H05K 3/24, H05K 3/42, G06K 19/077

(54) **DURCHKONTAKTIERUNG IN EINER BEIDSEITIG BEDRUCKTEN TRÄGERFOLIE UNTER VERWENDUNG EINER DIFFRAKTIVEN OPTIK UND VERFAHREN ZU SEINER HERSTELLUNG**
THROUGH-CONTACT IN A TWO-SIDED PRINTED SUBSTRATE BY USE OF DIFFRACTIVE OPTICS AND METHOD OF MANUFACTURING THE SAME
CONTACT TRAVERSANT DANS UN SUBSTRAT BIFACE PAR PERÇAGE AU MOYEN D'UNE OPTIQUE DIFFRACTANTE ET SON PROCÉDÉ DE FABRICATION

(30) Priorität: 06.11.2018 DE 102018127633
(43) Veröffentlichungstag der Anmeldung: 15.09.2021
(73) Patentinhaber: Bundesdruckerei GmbH, 10969 Berlin (DE)
(72) Erfinder: BAUDACH, Steffen, 13189 Berlin (DE); FERBER, Alexander, 12105 Berlin (DE)
(74) Vertreter: Hentrich Patent- & Rechtsanwaltspartnerschaft mbB
(86) Internationale Anmeldenummer: PCT/EP2019/079749
(87) Internationale Veröffentlichungsnummer: WO 2020/094491

(56) Entgegenhaltungen:
- EP-A1- 0 224 113
- EP-A2- 1 043 110
- WO-A1-2004/038793
- WO-A1-2014/095232
- WO-A1-2016/030665
- WO-A2-2013/139470
- US-A- 6 037 103
- US-A1- 2004 017 560
- US-A1- 2009 272 564
- US-A1- 2014 175 705

## Beschreibung

### Gegenstand der Erfindung

Die vorliegende Erfindung betrifft ein Verfahren zum Erzeugen einer Durchkontaktierung in einer beidseitig bedruckten Trägerfolie sowie eine beidseitig bedruckte Trägerfolie mit Durchkontaktierung.

### Hintergrund der Erfindung

In der US 6,037,103 A wird ein Verfahren beschrieben, bei dem ein Laserstrahl durch ein diffraktives optisches Element aufgeteilt wird, um eine Mehrzahl an Bohrungen in eine Leiterplatte auf einmal einzubringen. Hierbei wird der Laser auf ein Resin-Layer gerichtet, der damit den Weg zum leitfähigen Material freigibt.

In der US 2004 / 0 017 560 A1 wird ein Verfahren beschrieben, bei dem ein Laser zeitgleich an mehreren Stellen eines Substrats fokussiert wird, um Löcher in dem Substrat auszubilden. Hierfür wird ein diffraktives optisches Element (DOE) genutzt.

Die WO 2013 / 139 470 A2 beschreibt ein Substrat für einen portablen Datenträger, insbesondere eine Chipkarte, die einen ersten Antennenteil auf seiner einen Seite und einen zweiten Antennenteil auf seiner anderen Seite besitzt, wobei die beiden Antennenteile über die Durchkontaktierungsbereiche elektrisch miteinander verbindbar sind, beispielsweise mittels Silberleitpaste.

In der EP 0 224 113 A1 ist ein konventionelles Lasersystem beschrieben, bei dem ein Spülgas (Inertgas, z.B. Stickstoff) genutzt wird, um einen präzisen Schnitt zu bewirken.

In der US 2014 / 0 175 705 A1 wird ein Verfahren beschrieben, bei dem eine Durchkontaktierung beispielsweise mit Hilfe eines Laserschnitts bewirkt wird.

In der WO 2016 / 030 665 A1 sind eine Vorrichtung und ein Verfahren zur Durchführung einer Laserablation an einem Substrat beschrieben. Dabei wird eine Kupferlage freigelegt.

Die EP 1 043 110 A2 beschreibt die Herstellung eines RFID-Inlays, bei dem in eine Leiterplatte gleichzeitig eine Vielzahl von Bohrungen durch den Einsatz einer diffraktiven Optik eingebracht wird.

Die WO 2004 / 038 793 A1 beschreibt eine Identitätskarte, die mit einem RFID-Modul ausgestattet ist. Dabei sind die Elektroden auf ein- und derselben Seite der Substratschicht angeordnet, sodass keine Durchkontaktierung erforderlich ist.

In der US 2009 / 0 272 564 A1 wird ein Verfahren zur Herstellung einer mehrlagigen Leiterplatte beschrieben, wobei hier ebenfalls Durchkontaktierungen hergestellt werden.

In der WO 2014 / 095 232 A1 ist ein Verfahren zur Herstellung eines Inlays mit einer Antenne beschrieben, die einen Mikrochip kontaktiert unter Verwendung einer Klebstoffschicht. Dabei bildet die Klebstoffschicht einen Klebstoffmeniskus aus, der eine vorgegebene Form umfasst, die bei einer späteren Prüfung verifizierbar ist.

Mit Leiterbahnen bedruckte Trägerfolien sind im Stand der Technik also wohlbekannt, so beispielsweise auch aus WO2014/095232. So umfassen bspw. RFID-Etiketten ("radio frequency identification"-Etiketten bzw. Etiketten zur Identifizierung mit Hilfe elektromagnetischer Wellen) eine Antenne in Form einer auf einer Folie gedruckten Leiterbahn, die mit einem RFID-Chip verbunden ist und sowohl der Energieversorgung als auch der Kommunikation mit einem RFID-Lesegerät dient. Die Leiterbahn ist häufig spiralförmig ausgestaltet und ist an zwei voneinander entfernten Antennenabgriffen mit entsprechenden Kontakten des RFID-Chips verbunden.

Bei ausreichend großen RFID-Chips ist es möglich, die beiden Antennenabgriffe direkt mit dem RFID-Chip zu verbinden, indem der RFID-Chip unmittelbar auf die spiralförmige Leiterbahn aufgesetzt wird, wodurch zwei voneinander entfernt angeordnete Kontakte des RFID-Chips mit den Antennenabgriffen verbunden werden. Der RFID-Chip fungiert dabei als Brücke zwischen den beiden Antennenabgriffen über die zwischen den Antennenabgriffen gelegenen weiteren Wicklungen der Antenne.

### Beschreibung der Erfindung

Vor dem beschriebenen Hintergrund ist es Aufgabe der vorliegenden Erfindung, ein verbessertes, insbesondere effizienteres und präziseres, Verfahren zur Herstellung einer beidseitig bedruckten Trägerfolie zur Verfügung zu stellen, wobei insbesondere die Leitfähigkeit im Bereich der Durchkontaktierung weiter verbessert wird.

Diese Aufgabe wird durch Verfahren zum Erzeugen einer Durchkontaktierung in einer beidseitig mit Leiterbahnen bedruckten Trägerfolie nach Anspruch 1, eine Trägerfolie nach Anspruch 12, ein RFID-Inlay nach Anspruch 13 und ein Wert- oder Sicherheitsdokument nach Anspruch 14 gelöst. Die abhängigen Ansprüche enthalten weitere, vorteilhafte Ausgestaltungen der Erfindung.

Die Erfindung beruht auf der Erkenntnis und schließt diese mit ein, dass aufgrund der fortschreitenden Miniaturisierung der RFID-Chips eine Überbrückung der Antennenwicklungen zunehmend schwierig wird, da der Abstand der Kontakte der RFID-Chips häufig geringer ist als der minimale mit vertretbarem Aufwand herstellbare Abstand der beiden Antennenabgriffe der Leiterbahn.

Das erfindungsgemäße Verfahren zum Erzeugen einer Durchkontaktierung in einer beidseitig mit Leiterbahnen bedruckten Trägerfolie mit einer ersten und einer zweiten umfasst mehrere Schritte. Dabei ist die angegebene Reihenfolge der einzelnen Schritte nicht zwingend. Die erste Seite der Trägerfolie wird mit elektrisch leitendem Material bedruckt, wobei der Bereich der vorgesehenen Durchkontaktierung überdeckt wird. Es wird mindestens ein Durchgangsloch in die Trägerfolie im Bereich der vorgesehenen Durchkontaktierung mittels eines Lasers unter Verwendung mindestens einer diffraktiven Optik eingebracht. Es können auch mehrere diffraktive Optiken verwendet werden. Weiterhin wird die zweite Seite der Trägerfolie mit elektrisch leitendem Material bedruckt, wobei das mindestens eine Durchgangsloch mit elektrisch leitendem Material verfüllt wird.

Verfüllen ist im Zusammenhang mit der vorliegenden Erfindung so zu verstehen, dass über den gesamten Bereich bzw. die gesamte Querschnittsfläche des Durchgangsloches ein Materialschluss zwischen dem auf der ersten Seite und der zweiten Seite aufgedruckten elektrisch leitenden Material hergestellt wird. Ein vollständiges Auffüllen bzw. Ausfüllen des Durchgangslochs oder des in diesem Zusammenhang abgetragenen Volumens mit elektrisch leitendem Material bis zur Oberfläche der zweiten Seite ist von Vorteil, aber nicht zwingend erforderlich.

Die Verwendung einer diffraktiven Optik hat den Vorteil, dass hochpräzise Loch-Geometrien und Strukturen aus einer Mehrzahl an Löchern gefertigt werden können. Zudem kann die Bearbeitungszeit herabgesetzt werden, insbesondere durch die gleichzeitige Fertigung einer Mehrzahl an Löchern und/oder Strukturen. Bevorzugt wird im Rahmen des erfindungsgemäßen Verfahrens eine Mehrzahl an Durchgangslöchern in die Trägerfolie eingebracht. Insbesondere können mehrere Durchgangslöcher gleichzeitig in die Trägerfolie eingebracht werden. Zum Beispiel kann der Strahl einer Laserquelle durch eine entsprechend ausgestaltete diffraktive Optik zur parallelen bzw. gleichzeitigen Bearbeitung mehrerer, insbesondere aller, redundanter Durchgangslöcher genutzt werden. Hierdurch wird die Bearbeitungszeit reduziert und damit ein höherer Durchsatz realisiert. Die erzeugten Loch-Geometrien zeichnen sich durch eine hohe Gleichmäßigkeit und Reproduzierbarkeit aus, wobei Pulsschwankungen bzw. Jitter keine signifikanten Störungen der Geometrie verursachen. Insbesondere wird eine hohe Präzision und Reproduzierbarkeit der Positionen und Abstände der Durchgangslöcher oder der erzeugten Strukturen zueinander sichergestellt.

Das mindestens eine Durchgangsloch kann eine Mittelachse aufweisen und mittels des Lasers und der diffraktiven Optik kann innerhalb des Durchgangsloches in radialer Richtung Material abgetragen werden, wodurch insgesamt mehr Gestaltungsspielräume bei der Gestaltung der Lochgeometrie eröffnet werden. Es werden innerhalb des Durchgangsloches geometrische Strukturen, zum Beispiel in Form einer Nut, erzeugt. Vorteilhafterweise können mittels einer diffraktiven Optik mehrere Durchgangslöcher und/oder Strukturen gleichzeitig erzeugt werden. Durch eine entsprechende Gestaltung einer diffraktiven Optik kann der Strahl einer Laserquelle innerhalb eines Fokuspunktes verschiedene Wirkungen auf das Material haben und damit verschiedene geometrische Ausprägungen erzeugen. Damit ist die Erzeugung spezieller Strukturen auch in radialer Richtung möglich. Diese Strukturen können zum Beispiel als Sicherheitsmerkmale dienen. Entsprechend erzeugte Hinterschneidungen oder Strukturen in den Durchgangslöchern, die nach einer Lamination zum Beispiel mittels Röntgen noch sichtbar sind, sind extrem schwer mit anderen Mitteln nachzustellen und daher als Sicherheitsmerkmal sehr gut geeignet.

Um das Verfließen des Materials durch den Wärmeeintrag zu minimieren sind entsprechende Laserquellen zu bevorzugen. Zum Beispiel kann ein Laser, der ultrakurze Lichtimpulse mit einer Impulsdauer von maximal 10⁻⁹ Sekunden erzeugt, verwendet werden. Vorteilhafterweise wird ein Pikosekunden-Laser, also ein Laser mit einer Impulsdauer zwischen 10⁻⁹ und 10⁻¹² Sekunden, oder ein Femtosekunden-Laser, also ein Laser mit einer Impulsdauer zwischen 10⁻¹² und 10⁻¹⁵ Sekunden, verwendet. Es ist zudem von Vorteil, wenn während der Bearbeitung mittels des Lasers der bearbeitete Bereich der Trägerfolie mit Prozessgas, zum Beispiel mit Stickstoff, gespült wird. Auf diese Weise kann Materialabtrag aus Hinterschneidungen entfernt und ein Niederschlag des abgetragenen Materials auf der Laseroptik vermieden werden.

Das mindestens eine Durchgangsloch weist erfindungsgemäß in einer Draufsicht die Form eines Ringes auf. Eine Anzahl, insbesondere eine Mehrzahl, an Durchgangslöchern können eine Struktur bilden. Die Struktur kann mindestens ein Loch, beispielsweise ein Loch mit kreisförmigem, ovalem, rechteckigem oder quadratischem Querschnitt, und/oder mindestens einen Steg und/oder ein Logo umfassen. Die Struktur kann zum Beispiel gitterförmig angeordnete Stege aufweisen. Die genannten Strukturen können zum Beispiel mit entsprechenden Lasern, zum Beispiel einem Pikosekunden-Laser oder einem Femtosekunden-Laser, und mindestens einer diffraktiven Optik erzeugt werden.

Vorzugsweise erfolgt das Verfüllen mit elektrisch leitendem Material nur soweit, dass die Struktur sichtbar bleibt, zum Beispiel mittels Röntgen oder unter einem Mikroskop. Es können also beim anschließenden Antennendruck die Strukturen, die durch die Optik stehen gelassen wurden, zum Beispiel die Stege, zum Beispiel in der Form eines Gitters, und/oder das Logo, dünner verfüllt werden und stellen beispielsweise in einem aus der Trägerfolie gefertigten Dokument im Röntgen durch die Schichtdickenunterschiede ein sichtbares Sicherheitsmerkmal dar. Im Falle von stehen gelassenen Stegen können beim anschließenden Antennendruck die Öffnungen zwischen den Stegen verfüllt werden. Dabei kann die freigelegte Membran aus dem auf der ersten Seite der Trägerfolie aufgedruckten elektrisch leitenden Material durch die Stege stabilisiert werden, so dass effektiv größere Lochdurchmesser möglich sind.

Das Erzeugen von Strukturen erhöht die Freiheitsgrade bei der Erzeugung der Loch-Geometrien und erlaubt insbesondere im Fall von Gitterstrukturen größere LochDurchmesser. Dadurch wird die Stromtragfähigkeit erhöht und der elektrische Widerstand der Durchkontaktierung verringert.

Die genannten Strukturen, die nach einer späteren Lamination zum Beispiel mittels Röntgen oder unter einem Mikroskop noch sichtbar sind, sind extrem schwer mit anderen Mitteln nachzustellen und können daher als zusätzliches Sicherheitsmerkmal dienen. Dies gilt besonders im Fall von Strukturen, die mindestens ein Logo umfassen.

In einer weiteren Variante kann von einer Fläche der zweiten Seite im Bereich der vorgesehenen Durchkontaktierung Material flächig abgetragen werden, zum Beispiel mittels eines Lasers. Mindestens ein Durchgangsloch kann im Bereich der abgetragenen Fläche in die Trägerfolie eingebracht werden. Die zweite Seite der Trägerfolie wird anschließend mit elektrisch leitendem Material bedruckt, vorzugsweise teilweise bedruckt. Dabei werden die abgetragene Fläche und das Durchgangsloch mit elektrisch leitendem Material verfüllt. Durch einen zwei- oder mehrstufigen Übergang von der Oberfläche der zweiten Seite durch das mindestens eine Durchgangsloch zu dem auf der ersten Seite aufgebrachten elektrisch leitenden Material wird die Druckbarkeit des zu verfüllenden Materials verbessert. Insbesondere wird die Abrissneigung im Druckprozess durch die weniger steilen Kanten im Bereich der Durchkontaktierung verringert. Die Leitfähigkeit wird verbessert, da der effektive Durchmesser der verfüllten Durchgänge durch den flächigen Materialabtrag, zum Beispiel in Form einer Vorbohrung, steigt. Gleichzeitig ist der minimale kritische Durchmesser an der Membran geringer, weshalb der elektrische Widerstand ebenfalls sinkt. In dieser Variante wird vorzugsweise eine Mehrzahl an Durchgangslöchern im Bereich der abgetragenen Fläche in die Trägerfolie eingebracht. Die abgetragene Fläche kann eine kreisförmige, ovale, rechteckige oder eine andere Form aufweisen. Zur Vermeidung von Abrissen des Füllmaterials ist eine Form ohne Ecken, also eine kreisrunde oder ovale Form zu bevorzugen.

In einer speziellen Variante wird auf der abgetragenen Fläche Material von mindestens einer weiteren Fläche, die kleiner ist als die zuvor abgetragenen Fläche, flächig abgetragen wird. Dies hat den Vorteil, dass ein mehrstufiger, zum Beispiel trichterförmiger Übergang von der zweiten Seite der Trägerfolie zu dem auf der ersten Seite aufgebrachten oder noch aufzubringenden leitfähigen Material realisiert werden kann. Dadurch wird das Abrissrisiko weiter gesenkt und die Leitfähigkeit verbessert.

Das flächige Abtragen von Material und/oder das Einbringen mindestens eines Durchgangsloches können mittels eines Lasers erfolgen. Dabei kann das Abtragen von Material mittels eines Faser-Lasers und/oder mittels eines aufgeweiteten Laserstrahls und/oder mittels eines leistungsmäßig angepassten Laserstrahls erfolgen. Das flächige Abtragen von Material kann durch Verdampfen erfolgen. Aufgrund der Laserstabilität bei wechselnder abzurufender Leistung sind Faser-Laser zu bevorzugen.

Das Einbringen mindestens eines Durchgangslochs kann mittels eines gepulsten Lasers, insbesondere durch Perkussionsbohren, oder mittels eines CO2-Lasers erfolgen. Die Fertigung der Durchgangslöcher kann durch Laserbohrung infolge der durch das vorherige flächige Abtragen geringeren verbleibenden Materialstärke mit weniger Schüssen realisiert werden. Dadurch wird die Bearbeitungszeit verkürzt. Auch wenn beim Einbringen im ersten Druckschritt bzw. beim Bedrucken der ersten Seite aufgebrachtes elektrisch leitendes Material möglichst weitgehend erhalten bleiben soll, ist das Durchgangsloch bevorzugt durch Lasern einzubringen, da so die dabei erforderliche Genauigkeit ohne weiteres eingehalten werden kann.

Die erste Seite der Trägerfolie wird bevorzugt teilweise, nämlich im Bereich der vorgesehenen Durchkontaktierung, mit elektrisch leitendem Material bedruckt. Vorzugsweise wird der Bereich der vorgesehenen Durchkontaktierung vollständig mit elektrisch leitendem Material überdeckt.

Das Einbringen eines Durchgangslochs in die Trägerfolie kann vor dem Bedrucken der ersten Seite der Trägerfolie mit elektrisch leitendem Material erfolgen oder das Bedrucken der ersten Seite der Trägerfolie mit elektrisch leitendem Material kann vor dem Einbringen des Durchgangsloches in die Trägerfolie erfolgen. Insbesondere können alle Druckschritte unmittelbar nacheinander erfolgen. Alternativ dazu kann das Einbringen des Durchgangslochs nach dem Bedrucken der ersten Seite erfolgen, wobei das bereits aufgebrachte elektrisch leitende Material erhalten bleibt. Das Material aus dem ersten Druckschritt bildet also einen elektrisch leitenden Abschluss des Durchgangslochs, der eine gute elektrische Verbindung mit dem im zweiten Druckschritt in das Durchgangsloch eingebrachten elektrisch leitenden Material gewährleistet. Durch die genannten Varianten lässt sich das Verfahren flexibel in bereits bestehende Prozesse integrieren.

In einer vorteilhaften Variante wird die zweite Seite der Trägerfolie mit elektrisch leitendem Material mindestens ein weiteres Mal bedruckt, wobei die abgetragene Fläche, das Durchgangsloch und das bereits auf der zweiten Seite im Bereich der Durchgangsöffnung aufgedruckte elektrisch leitende Material verfüllt werden. Diese Variante hat den Vorteil, dass durch einen zusätzlichen Druckschritt ein Fülldruck vorgenommen wird, der dazu führt, dass mehr leitfähiges Material in der Durchkontaktierung vorhanden ist. Gleichzeitig wird eine erhöhte Stabilität gegenüber lateralen Einschnürungen in einer anschließenden Lamination erzielt. Weiterhin wird die Stromtragfähigkeit erhöht bzw. der elektrische Widerstand verringert. "Abrisse" des Fülldrucks an den Flanken des Durchgangsloches werden durch den weiteren Druck, zum Beispiel den Antennendruck, ausgeglichen. Damit ergeben sich höhere Ausbeuten und eine höhere Toleranz gegenüber ungünstigen Geometrien des Durchgangsloches. Löcher mit einem größeren Aspektverhältnis können verfüllt werden, zum Beispiel bei einer Verwendung dickerer Substrate, wenn aufgrund der Empfindlichkeit der freigelegten "Membran" der Lochdurchmesser nicht vergrößert werden kann.

Zum Beispiel können zunächst in einem ersten Druckschritt Leiterbahnen auf der ersten Seite der Trägerfolie aufgebracht werden, bevor nach Abschluss des ersten Druckschritts in einem zweiten und dritten Druckschritt der Fülldruck und Leiterbahnen, zum Beispiel als Antenne, auf die zweite Seite der Trägerfolie aufgebracht werden. Es ist aber auch möglich, dass mehrere Druckschritte gleichzeitig oder sich zeitlich überlappend ausgeführt werden.

Erfolgt das Einbringen des Durchgangslochs vor dem ersten Druckschritt oder erstreckt sich das Durchgangsloch bei Einbringen nach dem ersten Druckschritt auch durch das bereits aufgebrachte elektrisch leitendende Material, ist bevorzugt, wenn das Durchgangsloch derart dimensioniert ist, dass das in den darauffolgenden Druckschritten, insbesondere dem ersten und zweiten Druckschritt, aufgebrachte elektrisch leitende Material nicht durch das Durchgangsloch durchschießt. In anderen Worten soll das auf einer Seite der Trägerfolie aufgedruckte elektrisch leitende Material im Wesentlichen nicht durch das Durchgangsloch hindurch und frei auf der anderen Seite hinaustreten; vielmehr soll es in dem Durchgangsloch verbleiben, um dieses auszufüllen. Dies kann regelmäßig durch einen ausreichend kleinen, an die Fließeigenschaften des elektrisch leitenden Materials während des Druckvorgangs angepassten Querschnitt des Durchgangslochs insgesamt oder zumindest an der anderen Seite erreicht werden. Beispielsweise kann das Durchgangsloch kegelstumpfförmig mit einem zu der anderen Seite hin abnehmenden Querschnitt geformt werden.

Das Bedrucken, insbesondere das erste Bedrucken der zweiten Seite, kann mittels Siebdruck oder mittels eines Jet-Druckverfahrens erfolgen. Es sind aber auch andere Technologien denkbar, die zur Erhöhung der eingebrachten leitfähigen Materialmenge geeignet sind.

Der Durchmesser des Durchgangslochs kann 50 Mikrometer bis 5000 Mikrometer betragen. Insbesondere, wenn das Durchgangsloch nach dem ersten Druckschritt unter Erhaltung des dabei aufgebrachten elektrisch leitenden Materials eingebracht wird, ist bevorzugt, wenn der Durchmesser des Durchgangslochs 100 Mikrometer bis 500 Mikrometer beträgt. Durch einen entsprechenden Durchmesser ist eine sichere Durchkontaktierung mit hohem elektrischem Leitwert gewährleistet. Die Gefahr eines Durchschießens des im zweiten Druckschritt aufgebrachten Materials besteht in diesem Fall nicht. Insbesondere in den Fällen, in dem ein Durchschießen grundsätzlich möglich ist, beträgt der Durchmesser des Durchgangslochs vorzugsweise 50 Mikrometer bis 200 Mikrometer. Bei üblichen, für Druckverfahren verwendeten elektrisch leitenden Materialien kann dadurch ein Durchschießen des Materials vermieden werden. Die Dicke der Trägerfolie beträgt vorzugsweise 20 Mikrometer bis 250 Mikrometer, weiter vorzugsweise 50 Mikrometer bis 100 Mikrometer, so dass ein möglichst weitgehendes bis vollständiges Füllen des Durchgangslochs durch in einem Druckschritt aufgebrachtes elektrisch leitendes Material sichergestellt ist. Die Dicke der Trägerfolie und der Durchmesser des Durchgangslochs werden üblicherweise in Abhängigkeit voneinander gewählt, wobei eine dickere Trägerfolie mit einem größeren Durchmesser des Durchgangslochs einhergeht.

Auch wenn vorstehend Maße für den Durchmesser des Durchgangsloches angegeben sind, die die Formgebung des Durchgangsloches nicht auf die bevorzugte kreisrunde Ausgestaltung beschränkt. Im Falle eines nicht kreisrunden Durchgangslochs ist auf die mit den Durchmesserangaben unmittelbar verknüpfte Querschnittsfläche des Durchgangsloches abzustellen, also vorzugsweise 0,002 Quadratmillimeter bis 20,0 Quadratmillimeter, weiter vorzugsweise 0,008 Quadratmillimeter bis 0,2 Quadratmillimeter oder 0,002 Quadratmillimeter bis 0,03 Quadratmillimeter.

Das Einbringen des Durchgangslochs erfolgt erfindungsgemäß durch Lasern, vorzugsweise CO2-Lasern. Insbesondere wenn beim Einbringen im ersten Druckschritt bzw. beim Bedrucken der ersten Seite aufgebrachtes elektrisch leitendes Material möglichst weitgehend erhalten bleiben soll, ist das Durchgangsloch bevorzugt durch Lasern einzubringen, da so die dabei erforderliche Genauigkeit ohne weiteres eingehalten werden kann.

Es ist bevorzugt, wenn das elektrisch leitende Material Silberleitpaste umfasst oder aus Silberleitpaste besteht. Silberleitpaste eignet sich gut für den Druck von Leiterbahnen. Die Trägerfolie umfasst bevorzugt Polycarbonat oder besteht aus Polycarbonat. Eine Trägerfolie aus Polycarbonat kann mit weiteren Lagen aus Polycarbonat durch Laminieren zu einem als Schichtverbund aufgebauten RFID-Sicherheitsdokument verbunden werden, ohne dass sich eine erhöhte Gefahr von Delaminationen aufgrund inkompatibler Materialien der Schichten des Schichtverbundes ergäbe.

Die erfindungsgemäße, beidseitig mit Leiterbahnen bedruckte Trägerfolie weist wenigstens eine erfindungsgemäß hergestellte Durchkontaktierung auf. Zur weiteren Erläuterung wird auf die vorstehenden Ausführungen verwiesen. Falls der elektrische Leitwert einer Durchkontaktierung aufgrund der für das erfindungsgemäße Verfahren erforderlichen Dimensionierung des Durchgangsloches für eine vorgesehene Verwendung zu gering sein sollte, ist es möglich, jeweils eine Leiterbahn auf unterschiedlichen Seiten der Trägerfolie durch ein Feld von wenigstens zwei Durchkontaktierungen elektrisch miteinander zu verbinden. Die vorzugsweise eng benachbart zueinander angeordneten Durchkontaktierungen stellen so parallele Verbindungen zwischen den beiden Leiterbahnen her, wodurch sich ein erhöhter kumulierter elektrischer Leitwert zwischen den beiden Leiterbahnen ergibt. Zudem ergibt sich eine Redundanz der Durchkontaktierungen, wodurch eine ungenügende Kontaktierung in einer Durchkontaktierung durch eine gelungene Kontaktierung in einer anderen Durchkontaktierung aufgefangen wird.

Es ist weiter bevorzugt, wenn zwei durch wenigstens eine Durchkontaktierung verbundene Leiterbahnen auf der Trägerfolie Kontaktstellen zur Überprüfung der Durchkontaktierung(en) umfassen. An den Kontaktstellen können Prüfspitzen eines Messgerätes angelegt werden und so das grundsätzliche Bestehen einer elektrischen Verbindung über die Durchkontaktierung(en) und/oder der elektrische Widerstand bzw. der elektrische Leitwert der Durchkontaktierung(en) überprüft werden.

Das erfindungsgemäße RFID-Inlay umfasst eine erfindungsgemäße Trägerfolie und einem mit den Leiterbahnen verbundenen RFID-Chip. Das erfindungsgemäße Wertoder Sicherheitsdokument umfasst ein erfindungsgemäßes RFID-Inlay. Das erfindungsgemäße RFID-Inlay und erfindungsgemäße Wert- oder Sicherheitsdokument haben die oben bereits im Zusammenhang mit dem erfindungsgemäßen Verfahren und der erfindungsgemäßen Trägerfolie genannten Merkmale und Vorteile. Typische Beispiele für ein Wert- oder Sicherheitsdokument gemäß der vorliegenden Erfindung sind Personalausweise, Reisepässe, Führerscheine, Betriebsausweise, Kreditkarten, Verschlüsselungskarten und dergleichen mehr.

### Beschreibung von Ausführungsbeispielen

Weitere Merkmale, Eigenschaften und Vorteile der vorliegenden Erfindung werden im Folgenden anhand von Ausführungsvarianten unter Bezugnahme auf die beigefügten Figuren näher beschrieben.

Die Figuren sind nicht notwendigerweise detailgetreu und maßstabsgetreu und können vergrößert oder verkleinert dargestellt sein, um einen besseren Überblick zu bieten.

Der hier verwendete Ausdruck "und/oder", wenn er in einer Reihe von zwei oder mehreren Elementen benutzt wird, bedeutet, dass jedes der aufgeführten Elemente alleine verwendet werden kann, oder es kann jede Kombination von zwei oder mehr der aufgeführten Elementen verwendet werden. Wird beispielsweise eine Zusammensetzung beschrieben, dass sie die Komponenten A, B und/oder C, enthält, kann die Zusammensetzung A alleine; B alleine; C alleine; A und B in Kombination; A und C in Kombination; B und C in Kombination; oder A, B, und C in Kombination enthalten.
- Fig. 1: zeigt eine schematische Darstellung eines Ausführungsbeispiels eines RFID-Inlays mit einer erfindungsgemäßen Trägerfolie.
- Fig. 2a: zeigt eine schematische Detaildarstellung der Trägerfolie aus Figur 1.
- Fig. 2b: zeigt eine schematische Detaildarstellung einer Ausführungsvariante zu Figur 2a.
- Fig. 3: zeigt schematisch die ersten Schritte einer ersten Ausführungsvariante des erfindungsgemäßen Verfahrens zum Erzeugen einer Durchkontaktierung in einer beidseitig mit Leiterbahnen bedruckten Trägerfolie in einer Schnittansicht.
- Fig. 4: zeigt schematisch die ersten Schritte einer zweiten, nicht von der Erfindung erfassten Variante eines Verfahrens zum Erzeugen einer Durchkontaktierung in einer beidseitig mit Leiterbahnen bedruckten Trägerfolie in einer Schnittansicht.
- Fig. 5: zeigt schematisch die ersten Schritte einer dritten, von der Erfindung erfassten Variante eines Verfahrens zum Erzeugen einer Durchkontaktierung in einer beidseitig mit Leiterbahnen bedruckten Trägerfolie in einer Schnittansicht.
- Fig. 6: zeigt schematisch die in der Figur 5 gezeigte Trägerfolie in einer Draufsicht.
- Fig. 7: zeigt schematisch einen weiteren Schritt der dritten Ausführungsvariante des erfindungsgemäßen Verfahrens in einer Schnittansicht.
- Fig. 8: zeigt schematisch die in der Figur 7 gezeigte Trägerfolie in einer Draufsicht.
- Fig. 9: zeigt schematisch die ersten Schritte einer vierten, nicht von der Erfindung erfassten Variante eines Verfahrens zum Erzeugen einer Durchkontaktierung in einer beidseitig mit Leiterbahnen bedruckten Trägerfolie in einer Schnittansicht.
- Fig. 10: zeigt schematisch die in der Figur 9 gezeigte Trägerfolie in einer Draufsicht.
- Fig. 11: zeigt schematisch eine weitere Variante einer zu der in der Figur 9 gezeigten Trägerfolie analogen Trägerfolie in einer Draufsicht.
- Fig. 12: zeigt schematisch die in der Figur 11 gezeigte Trägerfolie nach einem weiteren Verfahrensschritt in einer Draufsicht.
- Fig. 13: zeigt schematisch die ersten Schritte einer fünften, nicht von der Erfindung erfassten Variante eines Verfahrens zum Erzeugen einer Durchkontaktierung in einer beidseitig mit Leiterbahnen bedruckten Trägerfolie.
- Fig. 14: zeigt schematisch einen weiteren Schritt der fünften Variante des Verfahrens.
- Fig. 15: zeigt schematisch die ersten Schritte einer sechsten, nicht von der Erfindung erfassten Variante eines Verfahrens zum Erzeugen einer Durchkontaktierung in einer beidseitig mit Leiterbahnen bedruckten Trägerfolie.
- Fig. 16: zeigt schematisch einen weiteren Schritt der sechsten Variante des Verfahrens.
- Fig. 17: zeigt schematisch noch einen weiteren Schritt der sechsten Variante des Verfahrens.
- Fig. 18: zeigt schematisch die ersten Schritte einer weiteren, nicht von der Erfindung erfassten Variante des Verfahrens.
- Fig. 19: zeigt schematisch einen weiteren Schritt dieser Variante des Verfahrens.
- Fig. 20: zeigt schematisch einen letzten Schritt dieser Variante des Verfahrens.

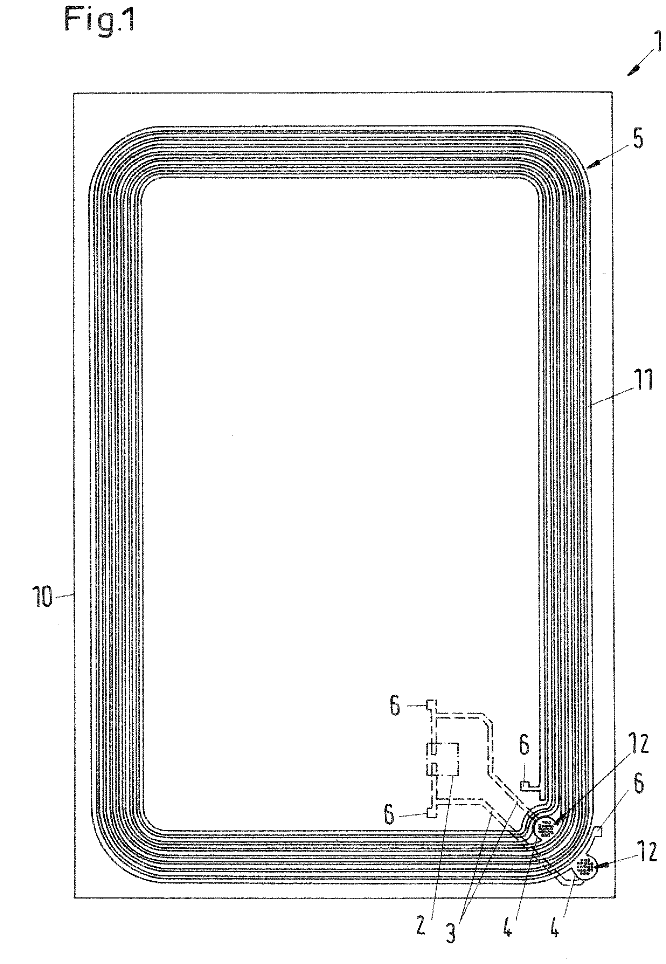

In Figur 1 ist ein RFID-Inlay 1, wie es in Sicherheitsdokumenten (bspw. Reisepässen) Verwendung findet, dargestellt. Das RFID-Inlay 1 umfasst eine erfindungsgemäße Trägerfolie 10, die beidseitig mit Leiterbahnen 11 bedruckt ist. In Figur 1 sind die Leiterbahnen 11 auf der unmittelbar sichtbaren Vorderseite der Trägerfolie 10 in durchgezogenen Linien, die Leiterbahnen 11 auf der Rückseite der Trägerfolie 10 in gestrichelten Linien dargestellt. Das RFID-Inlay 1 umfasst weiterhin den lediglich mit einer Strichpunktlinie angedeuteten RFID-Chip 2, der auf der Rückseite der Trägerfolie 10 angeordnet ist.

Der RFID-Chip 2 des RFID-Inlays 1 ist über Zuleitungen 3 mit Antennenabgriffen 4 einer Antenne 5 verbunden, wobei letztere neben Kommunikationszwecken auch der Energieversorgung dient. Die Zuleitungen 3, die Antennenabgriffe 4 und die Antenne 5 selbst sind durch die auf die Trägerfolie 10 aufgedruckten Leiterbahnen 11 gebildet. Auf der Vorderseite der Trägerfolie 10 ist die Leiterbahn 11 zur Bildung der Antenne 3 spiralförmig ausgestaltet und an den Antennenabgriffen 4 zu lediglich beispielhaft kreisförmig geformten Feldern erweitert. Auf der Rückseite sind die Leiterbahnen 11 als zwei separate Zuleitungen 3 ausgestaltet, die jeweils an ihrem einen Ende (in Figur 1 durch die Antennenabgriffe 4 verdeckte) kreisförmige Felder analog zu den Antennenabgriffen 4 auf der Vorderseite aufweisen. In dem gezeigten Ausführungsbeispiel sind die beiden Zuleitungen 3 an ihren anderen Enden auf einer gemeinsamen Achse aufeinander zulaufend ausgestaltet. Durch diese optionale, aber bevorzugte Ausgestaltung kann die Trägerfolie 10 flexibel mit verschiedenen RFID-Chips 2 bestückt werden, da durch das Layout der Leiterbahnen 11 kein Abstand für die Kontakte des RFID-Chips 2 vorgeschrieben ist, sondern RFID-Chips 2 mit unterschiedlichen Kontaktabständen so auf der Trägerfolie 10 angeordnet werden können, dass jeweils ein Kontakt mit einer Zuleitung 3 verbunden ist.

Zur Verbindung der Leiterbahnen 11 auf der Vorder- und Rückseite der Trägerfolie 10 sind im Bereich der Antennenabgriffe 4 Felder von Durchkontaktierungen 12 vorgesehen, mit denen die Antennenabgriffe 4 elektrisch mit den Zuleitungen 3 und somit die Antenne 5 mit dem RFID-Chip 2 verbunden werden.

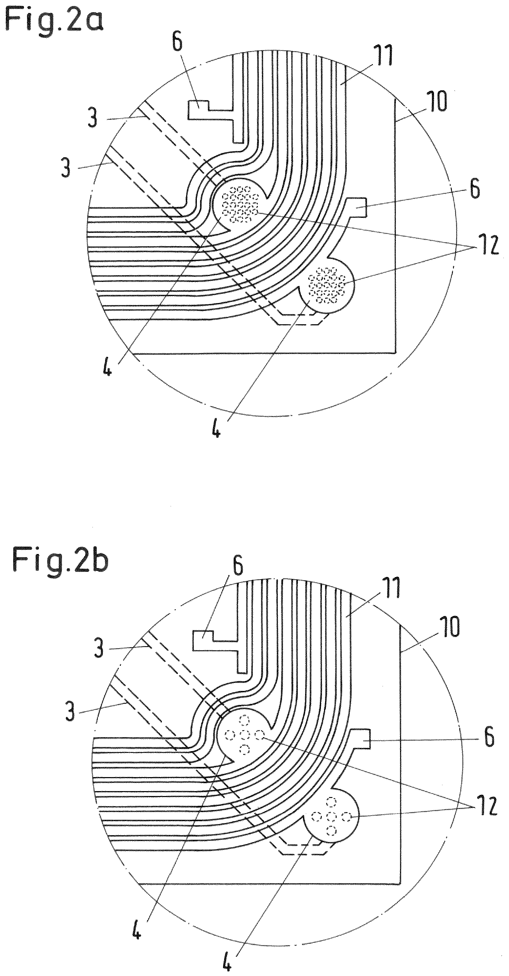

In Figuren 2a und b sind zwei verschiedene Ausführungsvarianten für das Feld von Durchkontaktierungen 12 in schematischen Detailansichten gezeigt, wobei die Variante aus Figur 2a der Darstellung aus Figur 1 entspricht. Die an sich durch die Leiterbahn 11 auf der Vorderseite verdeckten Durchkontaktierungen 12 sind durch Punktlinien angedeutet.

In der Ausführungsvariante gemäß Figur 2a sind im Bereich jedes Antennenabgriffs 4 jeweils 21 Durchkontaktierungen 12 vorgesehen, wobei jede Durchkontaktierung 12 einen Durchmesser von etwa 140 Mikrometer aufweist. In der Ausführungsvariante gemäß Figur 2b sind im Bereich jedes Antennenabgriffs 4 nur jeweils fünf Durchkontaktierungen 12 vorgesehen. Da diese aber jeweils einen Durchmesser von etwa 285 Mikrometer aufweisen, ist der kumulierte elektrische Leitwert eines jeweiligen Feldes von Durchkontaktierungen 12 unter Annahme identischer Materialen und Dicke der Trägerfolie 10 bei beiden Ausführungsvarianten praktisch identisch.

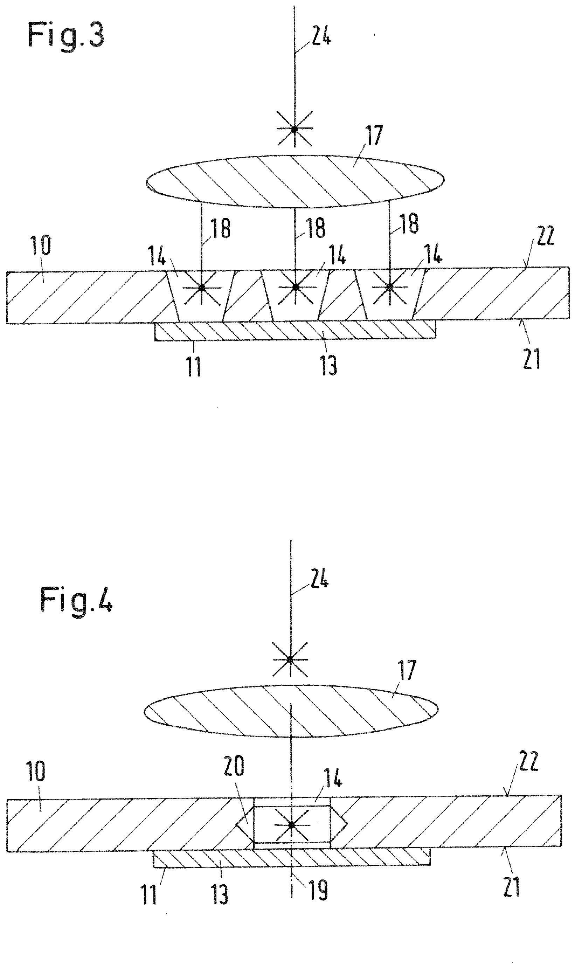

Die Durchkontaktierungen 12 der Trägerfolie 10 des RFID-Chips aus den Figuren 1 und 2a, b sind in einem erfindungsgemäßen Verfahren erzeugt worden. Ausführungsvarianten des erfindungsgemäßen Verfahrens werden im Folgenden anhand der Figuren 3 bis 20 näher erläutert. Die in den Figuren 3 bis 20 gezeigten Trägerfolien 10 umfasst eine erste Seite 21 und eine zweite Seite 22. Dabei kann es sich jeweils um eine Oberseite oder Unterseite oder eine Vorderseite oder Rückseite handeln.

Die Figur 3 zeigt schematisch die ersten Schritte einer ersten Ausführungsvariante des erfindungsgemäßen Verfahrens zum Erzeugen einer Durchkontaktierung in einer beidseitig mit Leiterbahnen bedruckten Trägerfolie 10. In einem ersten Schritt wird die erste Seite 21 der Trägerfolie 10 mit elektrisch leitendem Material 13 bedruckt, wobei der Bereich der vorgesehenen Durchkontaktierung überdeckt wird. Anschließend werden mehrere Durchgangslöcher 14 gleichzeitig in die Trägerfolie 10 im Bereich der vorgesehenen Durchkontaktierung mittels eines Lasers 24 unter Verwendung einer diffraktiven Optik 17, die den Strahl des Lasers 24 in mehrere Teilstrahlen 18 aufteilt, eingebracht. Dieses Vorgehen ermöglicht die gleichzeitige und damit effiziente Fertigung mehrerer Durchgangslöcher 14 mit hoher Präzision.

Die Figur 4 zeigt schematisch die ersten Schritte einer zweiten, nicht von der Erfindung erfassten Variante eines Verfahrens zum Erzeugen einer Durchkontaktierung in einer beidseitig mit Leiterbahnen bedruckten Trägerfolie 10. In dieser Variante wird im Anschluss an das Bedrucken der ersten Seite 21 der Trägerfolie 10 mit elektrisch leitendem Material 13 mittels des Lasers 24 unter Verwendung einer diffraktiven Optik 17 ein Durchgangsloch 14, welches eine Mittelachse 19 aufweist, in die Trägerfolie 10 eingebracht. Dabei wird mittels der diffraktiven Optik 17 in radialer Richtung bezüglich der Mittelachse 19 eine Struktur in Form einer Nut 20 in die Trägerfolie 10 eingebracht. Vorzugsweise wird hierfür ein Piko- oder Femtosekunden-Laser verwendet. Zudem kann eine Spülung mit Prozessgas, zum Beispiel mit Stickstoff, erfolgen.

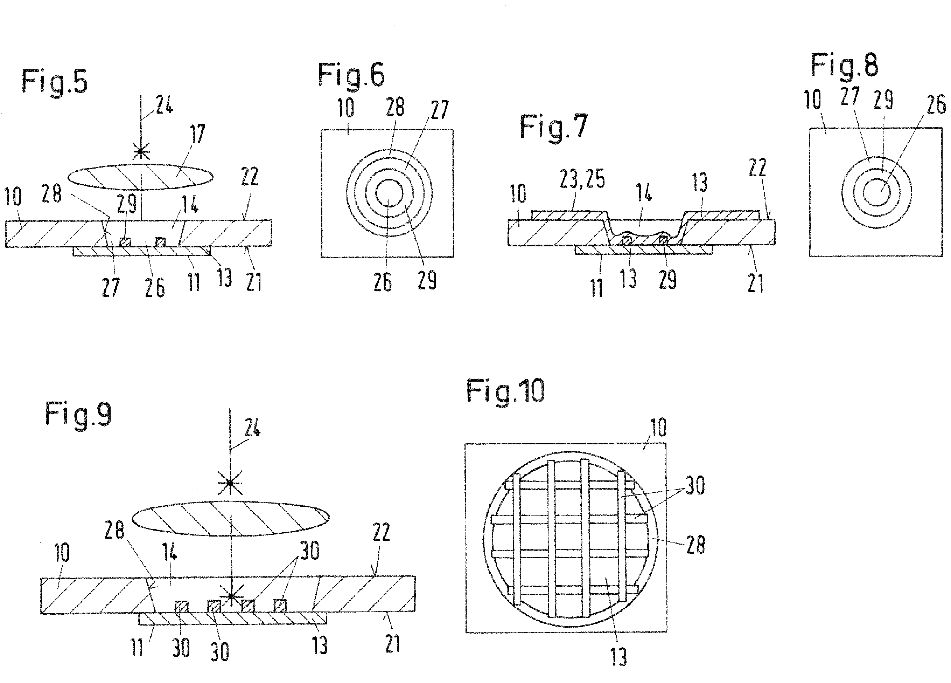

Die Figur 5 zeigt schematisch die ersten Schritte einer dritten, von der Erfindung erfassten Variante des Verfahrens zum Erzeugen einer Durchkontaktierung in einer beidseitig mit Leiterbahnen bedruckten Trägerfolie 10. In dieser Variante wird in die Trägerfolie 10 mittels des Lasers 24 unter Verwendung einer diffraktiven Optik 17 ein Durchgangsloch 14 eingebracht, welches ein Loch 26 mit einem kreisförmigen Querschnitt und konzentrisch außen um das Loch 26 angeordnetes ringförmiges Loch 27 umfasst. Zwischen dem Loch 26 und dem Loch 27 ist Material der Trägerfolie 10 in Form eines ringförmigen Steges 29 stehen gelassen worden. Die Seitenfläche des Durchgangslochs 14 ist mit der Bezugsziffer 28 gekennzeichnet. Die Figur 6 zeigt schematisch die in der Figur 5 gezeigte Trägerfolie 10 in einer Draufsicht.

Die Figur 7 zeigt schematisch das Bedrucken der zweiten Seite 22 der in den Figuren 5 und 6 gezeigten Trägerfolie 10 mit elektrisch leitendem Material 13. Dabei wird das Durchgangsloch 14 mit elektrisch leitendem Material 13 verfüllt wird. Bei der so erzeugten Schicht kann es sich um eine Fülldruckschicht 23 oder eine Antennendruckschicht 25 handeln. Bevorzugt werden die Strukturen, die durch die diffraktive Optik 17 stehen gelassen wurden, also im vorliegenden Beispiel der ringförmige Steg 29, dünner verfüllt und stellen somit in einer fertigen Karte oder einem anderen die Trägerfolie 10 umfassenden Dokument oder Bauteil durch die Schichtdickenunterschiede ein zum Beispiel unter einem Mikroskop oder im Röntgen sichtbares Sicherheitsmerkmal dar. Die Figur 8 zeigt schematisch die in der Figur 7 gezeigte Trägerfolie 10 in einer Draufsicht, beispielsweise im Röntgen oder unter einem Mikroskop. Die ringförmige Struktur ist als Sicherheitsmerkmal erkennbar.

Die Figur 9 zeigt schematisch die ersten Schritte einer vierten, nicht von der Erfindung erfassten Variante eines Verfahrens zum Erzeugen einer Durchkontaktierung in einer beidseitig mit Leiterbahnen bedruckten Trägerfolie 10. Die Figur 10 zeigt schematisch die in der Figur 9 gezeigte Trägerfolie in einer Draufsicht.

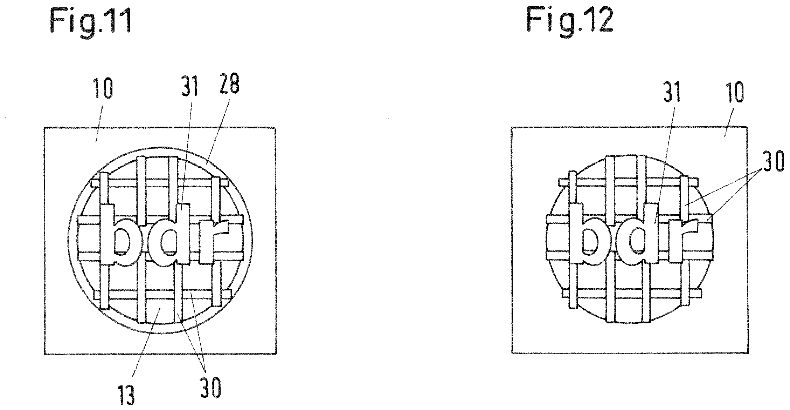

In dieser Variante wurden analog zu dem im Zusammenhang mit der Figur 5 beschriebenen Verfahren gitterförmig angeordnet Stege 30 bei der Fertigung des Durchgangslochs 14 stehen gelassen. In der in der Figur 11 gezeigten Draufsicht wurde zusätzlich zu den Stegen 30 ein Logo 31 stehen gelassen. In der Figur 12 ist schematisch die in der Figur 11 gezeigte Trägerfolie 10 nach dem Verfüllen des Durchgangslochs 14 mit elektrisch leitendem Material 13 in einer Draufsicht gezeigt, beispielsweise unter einem Mikroskop oder in einer Röntgenaufnahme. Das Logo kann also als zusätzliches Sicherheitsmerkmal dienen.

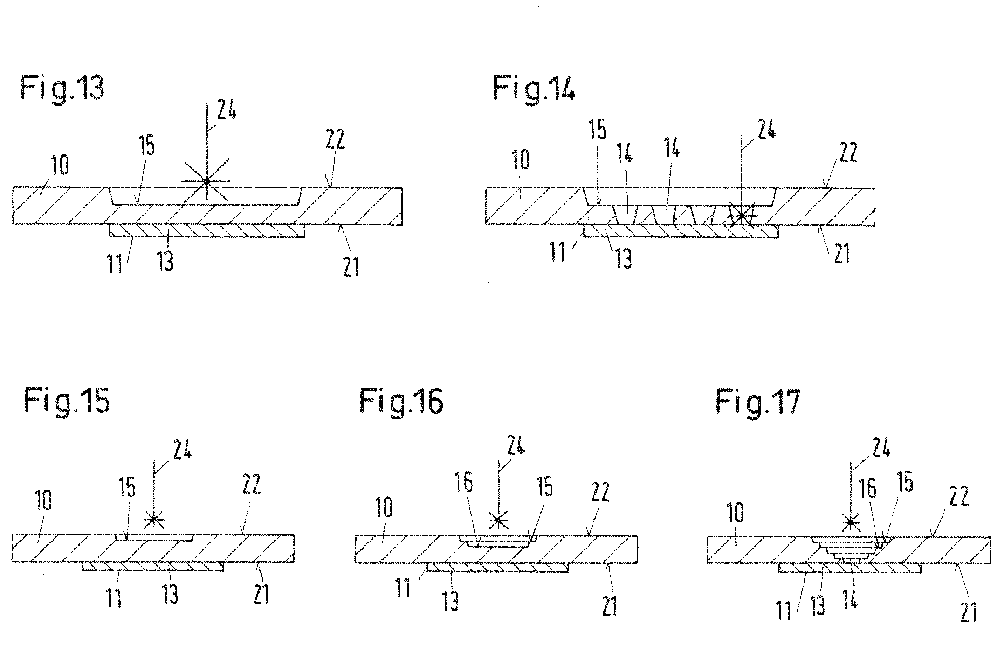

Die Figur 13 zeigt schematisch die ersten Schritte einer weiteren, nicht erfindungsgemäßen Variante eines Verfahrens zum Erzeugen einer Durchkontaktierung in einer beidseitig mit Leiterbahnen bedruckten Trägerfolie 10. In einem optional ersten Schritt wird die erste Seite 21 der Trägerfolie 10 im Bereich der vorgesehenen Durchkontaktierung 12 mit elektrisch leitendem Material 13, zum Beispiel Silberleitpaste, bedruckt. Dabei kann der Druck beispielsweise den Druck von Leiterbahnen 11 umfassen. Das Bedrucken der ersten Seite 21 kann auch im Anschluss an die Fertigung des Durchgangs durch die Trägerfolie 10 erfolgen.

Außerdem wird auf der zweiten Seite 22 im Bereich der vorgesehenen Durchkontaktierung 12 flächig Material abgetragen. Die abgetragene Fläche ist mit der Bezugsziffer 15 gekennzeichnet. Das Abtragen kann durch Verdampfen mittels eines Lasers 24, vorzugsweise eines CO2-Lasers, erfolgen. Dabei kann ein entsprechend aufgeweiteter Strahl, der zum Beispiel mittels einer Defokussierung im Strahlengang des Lasers erzeugt wird, und/oder ein leistungsmäßig angepasster Strahl verwendet werden.

In einem in der Figur 14 schematisch gezeigten weiteren Schritt werden im Bereich der abgetragenen Fläche 15 eine Mehrzahl an Durchgangslöchern 14 in die Trägerfolie 10 eingebracht. Dies kann ebenfalls mittels eines Lasers 24, zum Beispiel durch Perkussionsbohren erfolgen. Anschließend wird die zweite Seite 22 der Trägerfolie 10 mit in der Figur 14 nicht gezeigtem elektrisch leitenden Material bedruckt, wobei die abgetragene Fläche 15 und die Durchgangslöcher 14 vorzugsweise vollständig überdeckt werden.

In einer weiteren, nicht von der Erfindung erfassten Variante wird, wie in der Figur 15 schematisch gezeigt, ein erster Materialabtrag 15, wie bereits im Zusammenhang mit der Figur 13 beschrieben, vorgenommen. Im Unterschied zu der in der Figur 13 gezeigten Variante wird eine kleinere Fläche in einer geringeren Tiefe abgetragen. Anschließend wird, wie in der Figur 16 gezeigt, auf der bereits abgetragenen Fläche 15 eine weitere Fläche 16 in derselben Weise abgetragen, wobei die weitere Fläche 16 keiner ist als die zuvor abgetragene Fläche 15. Der Abtrag weiterer Flächen wird, wie in der Figur 17 schematisch gezeigt, analog fortgesetzt, bis ein Durchgangsloch 14 erzeugt wurde. Der Materialabtrag kann durch Laserbohren mit mehreren Pulsen bei in Stufen reduziertem Strahldurchmesser, beispielsweise über eine Defokussierung bzw. Fokusverstellung, und mit entsprechender Leistungsanpassung zum Abtrag immer geringerer Flächen erfolgen. Aufgrund der Laserstabilität bei wechselnder abzurufender Leistung sind Faser-Laser zu bevorzugen.

Die sukzessiv abgetragenen Flächen weisen vorzugsweise einen kreisförmigen Querschnitt mit von Fläche zu Fläche abnehmendem Durchmesser auf. Dadurch wird auf einfache Weise ein gestuft konischer oder trichterförmiger Durchgang durch die Trägerfolie erzeugt, der die oben bereits genannten Vorteile bietet.

Anschließend wird die zweite Seite 22 der Trägerfolie 10 mit in der Figur 17 nicht gezeigtem elektrisch leitendem Material bedruckt, wobei die abgetragenen Flächen 15, 16 und das Durchgangsloch 14 vorzugsweise vollständig überdeckt werden.

Die beschriebenen Varianten können auch miteinander kombiniert werden. Zum Beispiel können in der in der Figur 17 gezeigten Variante eine Mehrzahl an Durchgangslöchern 14 in die Trägerfolie 10 eingebracht werden.

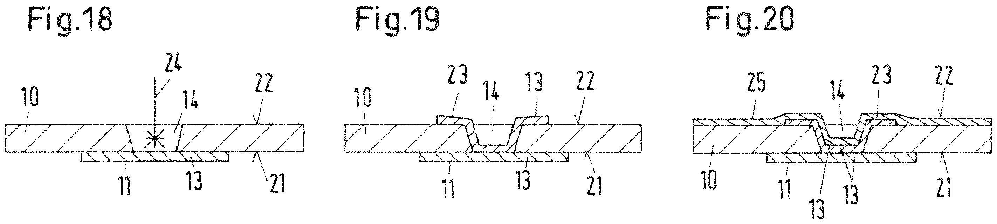

Im Folgenden wird anhand der Figuren 18 bis 20 eine Variante beschrieben, in der zusätzlich ein Fülldruck aufgebracht wird. Die im Folgenden beschriebene Verfahrensvariante kann auf die wie zuvor beschrieben erzeugten gestuften Durchgänge durch die Trägerfolie 10 angewendet werden.

In der vorliegenden Variante wird, wie in der Figur 18 schematisch in einer Schnittansicht gezeigt, zunächst die erste Seite 21 der Trägerfolie 10 im Bereich der vorgesehenen Durchkontaktierung mit elektrisch leitendem Material 13, zum Beispiel Silberleitpaste, bedruckt. Dabei kann der Druck beispielsweise den Druck von Leiterbahnen 11 umfassen. Anschließend wird von der zweiten Seite 22 aus, wie anhand der Figuren 13 bis 17 beschrieben, ein vereinfacht dargestelltes Durchgangsloch 14 in die Trägerfolie 10 eingebracht, optional unter vorherigem flächigen Materialabtrag. Dies kann mittels eines Lasers 24, vorzugsweise eines CO2-Lasers, aber auch durch Stanzen oder Bohren erfolgen.

In einem anschließenden Schritt, der in der Figur 19 schematisch in einer Schnittansicht gezeigt ist, wird die zweite Seite 22 der Trägerfolie 10 mit elektrisch leitendem Material 13, zum Beispiel Silberleitpaste, bedruckt, wobei das Durchgangsloch 14 vollständig verfüllt wird. Der so erzeugte Fülldruck ist mit der Bezugsziffer 23 gekennzeichnet. Durch den Fülldruck 23 wird sichergestellt, dass die Seitenflächen und Kanten des Durchgangslochs 14 vollständig mit leitfähigem Material überzogen werden.

Danach wird in dem in der Figur 20 gezeigten Schritt die zweite Seite 22 der Trägerfolie 10 mit elektrisch leitendem Material 13, zum Beispiel Silberleitpaste, erneut bedruckt, wobei das Durchgangsloch 14 und der Fülldruck vollständig überdeckt und verfüllt werden. Der so erzeugte Antennendruck ist mit der Bezugsziffer 25 gekennzeichnet.

Der Fülldruck 23 bewirkt, dass mehr leitfähiges Material in dem Durchgangsloch 14 bzw. in der Durchkontaktierung 12 platziert wird. Dadurch werden eine höhere mechanische Stabilität und ein geringerer elektrischer Widerstand erreicht.

Alternativ zu der gezeigten Variante kann auch zuerst der Materialabtrag 15, 16 vorgenommen und das Durchgangsloch 14 in die Trägerfolie 10 eingebracht werden, zum Beispiel mittels eines Lasers 24. Anschließend kann die erste Seite 21 mit leitfähigem Material 13 bedruckt werden, zum Beispiel im Rahmen des Drucks von Leiterbahnen 11. Daran anschließend kann der Fülldruck 23 aufgebracht werden und abschließend der Antennendruck 25.

Es können auch mehrere Fülldruckschritte vorgenommen werden um die Menge des in dem Durchgangsloch 14 vorhandenen leitfähigen Materials 13 noch weiter zu erhöhen.

Bei dem Bedrucken der ersten Seite 21 kann es sich auch um den Antennendruck und bei dem abschließenden, den Fülldruck überdeckenden Bedrucken der zweiten Seite 22 um den Druck der Leiterbahnen handeln.

### Bezugszeichenliste:

- 1: RFID-Inlay
- 2: RFID-Chip
- 3: Zuleitung
- 4: Antennenabgriff
- 5: Antenne
- 6: Kontaktstellen
- 10: Trägerfolie
- 11: Leiterbahn
- 12: Durchkontaktierung
- 13: elektrisch leitendes Material
- 14: Durchgangsloch
- 15: abgetragene Fläche
- 16: abgetragene Fläche
- 17: diffraktive Optik
- 18: Laserstrahlen
- 19: Mittelachse
- 20: Nut
- 21: erste Seite
- 22: zweite Seite
- 23: Fülldruckschicht
- 24: Laser
- 25: Antennendruckschicht
- 26: kreisförmiges Loch
- 27: ringförmiges Loch
- 28: Seitenfläche
- 29: ringförmiger Steg
- 30: gitterförmig angeordnete Stege
- 31: Logo

## Patentansprüche

1. Verfahren zum Erzeugen einer Durchkontaktierung (12) in einer beidseitig mit Leiterbahnen (11) bedruckten Trägerfolie (10), wobei die Trägerfolie (10) eine erste Seite (21) und eine zweite Seite (22) umfasst,
wobei das Verfahren folgende Schritte umfasst:
- Bedrucken der ersten Seite (21) der Trägerfolie (10) mit elektrisch leitendem Material (13), wobei der Bereich der vorgesehenen Durchkontaktierung (12) überdeckt wird,
- Einbringen mindestens eines Durchgangsloches (14) in die Trägerfolie (10) im Bereich der vorgesehenen Durchkontaktierung mittels eines Lasers (24) unter Verwendung mindestens einer diffraktiven Optik (17), und
- Bedrucken der zweiten Seite (22) der Trägerfolie (10) mit elektrisch leitendem Material (13), wobei das mindestens eine Durchgangsloch (14) mit elektrisch leitendem Material (13) verfüllt wird,
**dadurch gekennzeichnet, dass** das mindestens eine Durchgangsloch (14) in einer Draufsicht die Form eines Ringes aufweist.

2. Verfahren nach Anspruch 1, **dadurch gekennzeichnet, dass** das mindestens eine Durchgangsloch (14) eine Mittelachse (19) aufweist und mittels des Lasers (24) und der diffraktiven Optik (17) innerhalb des Durchgangsloches (14) in radialer Richtung Material abgetragen wird.

3. Verfahren nach einem der vorhergehenden Ansprüche, **dadurch gekennzeichnet, dass** mittels einer diffraktiven Optik (17) mehrere Durchgangslöcher (14, 26, 27) und/oder Strukturen (26, 27, 29, 30, 31) gleichzeitig erzeugt werden.

4. Verfahren nach einem der vorhergehenden Ansprüche, **dadurch gekennzeichnet, dass** ein Laser (24), der ultrakurze Lichtimpulse mit einer Impulsdauer von maximal 10⁻⁹ Sekunden erzeugt, verwendet wird.

5. Verfahren nach Anspruch 4, **dadurch gekennzeichnet, dass** ein Pikosekunden-Laser oder ein Femtosekunden-Laser verwendet wird.

6. Verfahren nach einem der vorhergehenden Ansprüche, **dadurch gekennzeichnet, dass** während der Bearbeitung mittels des Lasers (24) der bearbeitete Bereich der Trägerfolie (10) mit Prozessgas gespült wird.

7. Verfahren nach einem der vorhergehenden Ansprüche, **dadurch gekennzeichnet, dass** eine Anzahl an Durchgangslöchern eine Struktur (26, 27, 29, 30, 31) bilden, und dass die Struktur mindestens ein Loch (14, 26, 27) und/oder mindestens einen Steg (29, 30) und/oder ein Logo (31) umfasst.

8. Verfahren nach Anspruch 7, **dadurch gekennzeichnet, dass** das Verfüllen mit elektrisch leitendem Material (13) nur soweit erfolgt, dass die Struktur (26, 27, 29, 30, 31) sichtbar bleibt.

9. Verfahren nach einem der vorhergehenden Ansprüche, **dadurch gekennzeichnet, dass** vor dem Einbringen des mindestens einen Durchgangsloches (14) Material von einer Fläche (15) der zweiten Seite (22) im Bereich der vorgesehenen Durchkontaktierung flächig abgetragen wird.

10. Verfahren nach Anspruch 9, **dadurch gekennzeichnet, dass** auf der abgetragenen Fläche (15) Material von mindestens einer weiteren Fläche (16), die kleiner ist als die zuvor abgetragene Fläche (15), flächig abgetragen wird.

11. Verfahren nach Anspruch 9 oder 10, **dadurch gekennzeichnet, dass** das Abtragen von Material (15, 16) und/oder das Einbringen des mindestens einen Durchgangslochs (14) in die Trägerfolie (10) vor dem Bedrucken der ersten Seite (21) der Trägerfolie (10) mit elektrisch leitendem Material (13) erfolgt oder das Bedrucken der ersten Seite (21) der Trägerfolie (10) mit elektrisch leitendem Material (13) vor dem Abtragen von Material und/oder dem Einbringen des mindestens einen Durchgangsloches (14) in die Trägerfolie (10) erfolgt.

12. Trägerfolie (10), welche beidseitig mit Leiterbahnen (11) bedruckt ist und wenigstens eine gemäß einem der vorhergehenden Ansprüche hergestellte Durchkontaktierung (12) aufweist.

13. RFID-Inlay (1) mit einer Trägerfolie (10) gemäß dem vorhergehenden Anspruch und einem mit den Leiterbahnen (11) verbundenen RFID-Chip (2).

14. Wert- oder Sicherheitsdokument mit einem RFID-Inlay (1) gemäß dem vorhergehenden Anspruch.

## Claims

1. A method for producing a via plating (12) in a carrier film (10) printed on both sides with conductor tracks (11), wherein the carrier film (10) comprises a first side (21) and a second side (22),
wherein the method comprises the following steps:
- Printing of the first side (21) of the carrier film (10) with electrically conductive material (13), whereby the area of the intended via plating (12) is covered,
- Introduction of at least one through hole (14) into the carrier film (10) in the region of the intended via plating by means of a laser (24) using at least one diffractive optics (17), and
- Printing of the second side (22) of the carrier film (10) with electrically conductive material (13), wherein the at least one through hole (14) is filled with electrically conductive material (13),
**characterized in that** the at least one through hole (14) has the shape of a ring in a plan view.

2. The method according to claim 1, **characterized in that** the at least one through hole (14) has a center axis (19) and material is ablated in the radial direction within the through hole (14) by means of the laser (24) and the diffractive optics (17).

3. The method according to any one of the preceding claims, **characterized in that** a plurality of through holes (14, 26, 27) and/or structures (26, 27, 29, 30, 31) are produced simultaneously by means of diffractive optics (17).

4. The method according to any one of the preceding claims, **characterized in that** a laser (24) which generates ultrashort light pulses with a pulse duration of at most 10⁻⁹ seconds is used.

5. The method according to claim 4, **characterized in that** a picosecond laser or a femtosecond laser is used.

6. The method according to any one of the preceding claims, **characterized in that** during processing by means of the laser (24), the processed region of the carrier film (10) is flushed with process gas.

7. The method according to any one of the preceding claims, **characterized in that** a number of through holes form a structure (26, 27, 29, 30, 31), and that the structure comprises at least one hole (14, 26, 27) and/or at least one web (29, 30) and/or a logo (31).

8. The method according to claim 7, **characterized in that** the filling with electrically conductive material (13) is carried out only to the extent that the structure (26, 27, 29, 30, 31) remains visible.

9. The method according to any one of the preceding claims, **characterized in that**, before the introduction of the at least one through hole (14), material is removed in a planar manner from a surface (15) of the second side (22) in the region of the intended via plating.

10. The method according to claim 9, **characterized in that** material from at least one further area (16), which is smaller than the previously removed surface (15), is removed over a large area on the removed surface (15).

11. The method according to claim 9 or 10, **characterized in that** the removal of material (15, 16) and/or the introduction of the at least one through hole (14) into the carrier film (10) takes place before the printing of the first side (21) of the carrier film (10) with electrically conductive material (13) or the printing of the first side (21) of the carrier film (10) with electrically conductive material (13) takes place before the removal of material and/or the introduction of the at least one through hole (14) into the carrier film (10).

12. A carrier film (10), which is printed on both sides with conductor tracks (11) and which has at least one via plating (12) produced in accordance with any one of the preceding claims.

13. A RFID inlay (1) with a carrier film (10) according to the preceding claim and with a RFID chip (2) connected to the conductor tracks (11).

14. A value or security document with a RFID inlay (1) according to the preceding claim.

## Revendications

1. Procédé pour générer un contact traversant (12) dans un film de support (10) imprimé des deux côtés avec des pistes conductrices (11), dans lequel le film de support (10) comprend un premier côté (21) et un second côté (22), dans lequel le procédé comprend les étapes suivantes :
- impression du premier côté (21) du film de support (10) avec un matériau électriquement conducteur (13), dans lequel la zone du contact traversant (12) prévu est recouverte,
- pratique d'au moins un trou traversant (14) dans le film de support (10) dans la zone du contact traversant prévu au moyen d'un laser (24) en utilisant au moins une optique diffractive (17), et
- impression du second côté (22) du film de support (10) avec un matériau électriquement conducteur (13), dans lequel l'au moins un trou traversant (14) est faussé avec un matériau électriquement conducteur (13), **caractérisé en ce que** le au moins un trou traversant (14) a la forme d'un anneau dans une vue de dessus.

2. Procédé selon la revendication 1, **caractérisé en ce que** le au moins un trou traversant (14) présente un axe central (19) et du matériau est enlevé en direction radiale à l'intérieur du trou traversant (14) au moyen du laser (24) et de l'optique diffractive (17).

3. Procédé selon l'une quelconque des revendications précédentes, **caractérisé en ce que** plusieurs trous traversants (14, 26, 27) et/ou structures (26, 27, 29, 30, 31) sont générés simultanément au moyen d'une optique diffractive (17).

4. Procédé selon l'une quelconque des revendications précédentes, **caractérisé en ce qu'**un laser (24), qui génère des impulsions lumineuses ultracourtes d'une durée d'impulsion de 10-9 secondes au maximum, est utilisé.

5. Procédé selon la revendication 4, **caractérisé en ce qu'**un laser picoseconde ou un laser femtoseconde est utilisé.

6. Procédé selon l'une quelconque des revendications précédentes, **caractérisé en ce que**, pendant le traitement au moyen du laser (24), la zone traitée du film de support (10) est rincée avec du gaz de procédé.

7. Procédé selon l'une quelconque des revendications précédentes, **caractérisé en ce qu'**un certain nombre de trous traversants forment une structure (26, 27, 29, 30, 31), et **en ce que** la structure comprend au moins un trou (14, 26, 27) et/ou au moins une nervure (29, 30) et/ou un logo (31).

8. Procédé selon la revendication 7, **caractérisé en ce que** le remplissage avec un matériau électriquement conducteur (13) est effectué uniquement dans la mesure où la structure (26, 27, 29, 30, 31) reste visible.

9. Procédé selon l'une quelconque des revendications précédentes, **caractérisé en ce qu'**avant la pratique du au moins un trou traversant (14), du matériau est enlevé à plat d'une surface (15) du second côté (22) dans la zone du contact traversant prévu.

10. Procédé selon la revendication 9, **caractérisé en ce que** du matériau d'au moins une autre surface (16), qui est plus petite que la surface (15) précédemment enlevée, est enlevé à plat sur la surface enlevée (15).

11. Procédé selon la revendication 9 ou 10, **caractérisé en ce que** l'enlèvement de matériau (15, 16) et/ou la pratique d'au moins un trou traversant (14) dans le film de support (10) s'effectue avant l'impression du premier côté (21) du film de support (10) avec un matériau électriquement conducteur (13) ou l'impression du premier côté (21) du film de support (10) avec un matériau électriquement conducteur (13) s'effectue avant l'enlèvement de matériau et/ou la pratique d'au moins un trou traversant (14) dans le film de support (10).

12. Feuille de support (10), lequel est imprimé des deux côtés avec des pistes conductrices (11) et présente au moins un contact traversant (12) fabriqué selon l'une quelconque des revendications précédentes.

13. Insert RFID (1) avec un film de support (10) selon la revendication précédente et une puce RFID (2) connectée aux pistes conductrices (11).

14. Document de valeur ou de sécurité avec un insert RFID (1) selon la revendication précédente.
